Europäisches Patentamt

European Patent Office

Office européen des brevets

(19)

(11) Numéro de publication: **0 194 925**
**B1**

(12) # FASCICULE DE BREVET EUROPÉEN

(45) Date de publication du fascicule du brevet:
14.12.88

(51) Int. Cl.⁴: **C 22 C 19/05**

(21) Numéro de dépôt: **86400454.4**

(22) Date de dépôt: **05.03.86**

(54) **Alliage monocristallin à matrice à base de nickel.**

(30) Priorité: **06.03.85 FR 8503267**

(43) Date de publication de la demande:
**17.09.86 Bulletin 86/38**

(45) Mention de la délivrance du brevet:
**14.12.88 Bulletin 88/50**

(84) Etats contractants désignés:
**DE FR GB IT**

(56) Documents cité:
**EP-A-0 076 360**
**FR-A-2 007 572**
**FR-A-2 371 516**
**GB-A-1 087 051**
**GB-A-1 106 087**
**GB-A-2 071 695**

(73) Titulaire: **ASSOCIATION POUR LA RECHERCHE ET LE DEVELOPPEMENT DES METHODES ET PROCESSUS INDUSTRIELS (ARMINES), 60, Boulevard Saint- Michel, F-75272 Paris Cédex 06 (FR)**
Titulaire: **SOCIETE NATIONALE D'ETUDE ET DE CONSTRUCTION DE MOTEURS D'AVIATION, "S.N.E.C.M.A.", 2 Boulevard Victor, F-75015 Paris (FR)**

(72) Inventeur: **Bois, Françoise Jeanne, 7, square de la Prospérité, F-77240 - Cesson (FR)**
Inventeur: **Remy, Luc Gérard, 177, rue du Faubourg Poissonnière, F-75009 - Paris (FR)**
Inventeur: **Theret, Jean- Marc Clément, 26, Rue A. Soljénitsyne, F-91000 - Evry (FR)**

(74) Mandataire: **Moinat, François, S.N.E.C.M.A. Service des Brevets Boîte Postale 81, F-91003 Evry Cédex (FR)**

EP 0 194 925 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**0 194 925**

## Description

L'invention concerne des alliages monocristallins à matrice à base nickel, sans addition intentionnelle de carbone, de bore ou de zirconium.

De tels alliages sont connus par exemple par FR-A-2 557 598 ou par le document EP-A-0 063 511.

Le but de l'invention est de proposer une nouvelle famille d'alliages du type précité, adaptés à la coulée monocristalline, ayant une température de solidus élevée (i.e. supérieure à 1325° C) tout en conservant un intervalle de traitement thermique possible entre les températures de solidus et de solvus de phase gamma-prime, ces alliages présentant par ailleurs des propriétés mécaniques intéressantes relatives à la fatigue qui les rendent particulièrement aptes à leur utilisation dans le domaine aéronautique pour la fabrication d'aubes de distributeur de turbine.

Ce but est atteint conformément à l'invention par des alliages présentant la composition pondérale suivante :

| Co | 0 | à | 10 % |
|----|-----|---|--------|
| Cr | 5 | à | 7 % |
| Mo | 1,5 | à | 2,5 % |
| W | 8,5 | à | 12,5 % |
| Ta | 0 | à | 6,5 % |
| Al | 5 | à | 7 % |
| Nb | 0 | à | 2 % |
| Ni | complément à 100 | | |

avec par ailleurs la somme des pourcentages atomiques :

$0.005Co + 0.036Cr + 0.052Mo + 0,066W + 0.026Al + 0.116Nb + 0.049Ta$ inférieure ou égale à 1, ces alliages étant exempts de titane. Pour permettre la comparaison avec d'autres familles d'alliages contenant notamment du titane, la relation précédente devrait être appliquée en affectant au pourcentage atomique de titane un coefficient multiplicatif de 0,078.

On donne ci-après la justification des choix principaux des fourchettes de composition retenues et des exemples de réalisation, en référence aux dessins annexés sur lesquels :

- la figure 1 est un graphique montrant l'effet de la teneur en chrome (pourcentage pondéral porté en abscisse) sur les températures (portées en ordonnées) de liquidus, de solidus et de solvus gamma-prime.
- la figure 2 est un graphique similaire à celui de la figure 1, mais concernant l'effet de la teneur en tantale.
- La figure 3 représente la courbe d'endurance de Manson Coffin à 900°C pour un alliage de l'invention et deux alliages commerciaux MarM200 Hf à structure colonnaire et MarM200 à structure monocristalline. L'amplitude de la déformation totale $\Delta\varepsilon_t$ est portée en ordonnée en fonction du nombre de cycles à la rupture Nf porté en abscisse.
- La figure 3a représente les résultats d'un test similaire à ceux de la figure 3 pour un alliage de l'invention et un autre alliage commercial PD21 avec une déformation totale imposée $\Delta\varepsilon_t$ de 1,2 %. Le nombre de cycles à la rupture Nf est porté en ordonnées
- la figure 4 représente une courbe similaire à celle de la figure 3 mais établie à 1000°C.
- La figure 5 compare des alliages de l'invention et trois alliages commerciaux IN100 à structure équiaxe, René 125 à structure colonnaire et Mar M200 à structure colonnaire, vis à vis de la fatigue thermique, le nombre de cycles avant fissuration étant porté en ordonnées.
- Les figures 6 et 7 comparent respectivement à 900 et 1000°C, un alliage de l'invention, un alliage proche de l'invention et un alliage commercial Mar M 200 à structure monocristalline, vis à vis de la fatigue oligocyclique à déformation imposée. La durée de vie Nf est portée en abscisse en fonction de la déformation totale imposée $\Delta\varepsilon_t$ portée en ordonnée.

L'introduction de tungstène contribue à la stabilité de la phase gamma-prime. Il est préférable de maintenir la somme atomique $Ta + W + Mo + Nb$ entre 5,9 et 6,3 pour éviter une précipitation de phase primaire massive.

L'addition de cobalt ne change pas les températures de liquidus et de solidus mais diminue la température de solvus de gamma-prime: le cobalt augmente la fenêtre de remise en solution de la phase gamma-prime, ce qui facilite la réalisation des traitements thermiques.

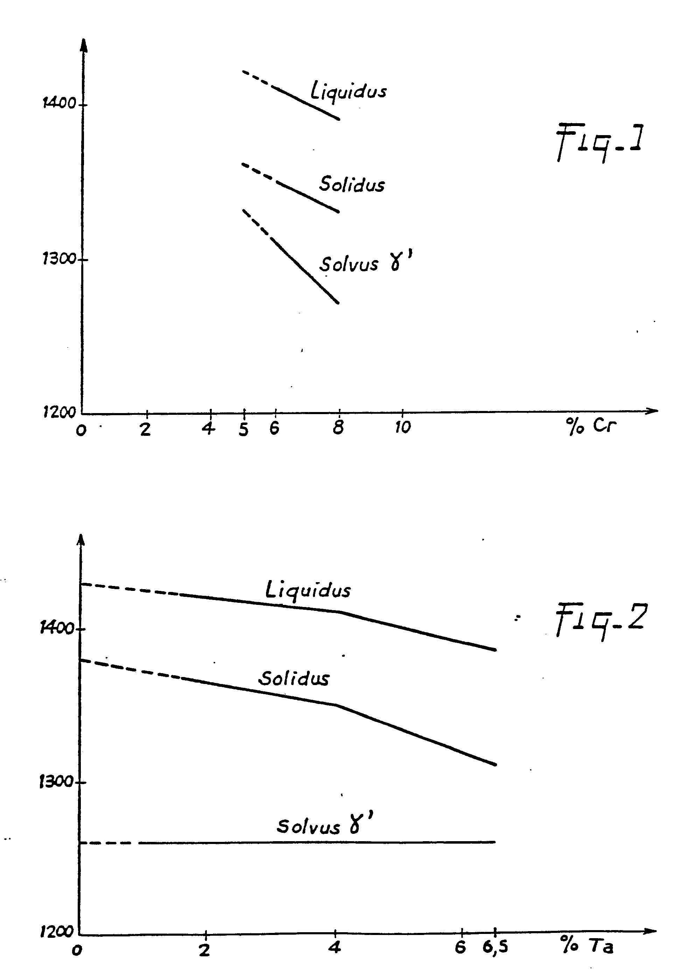

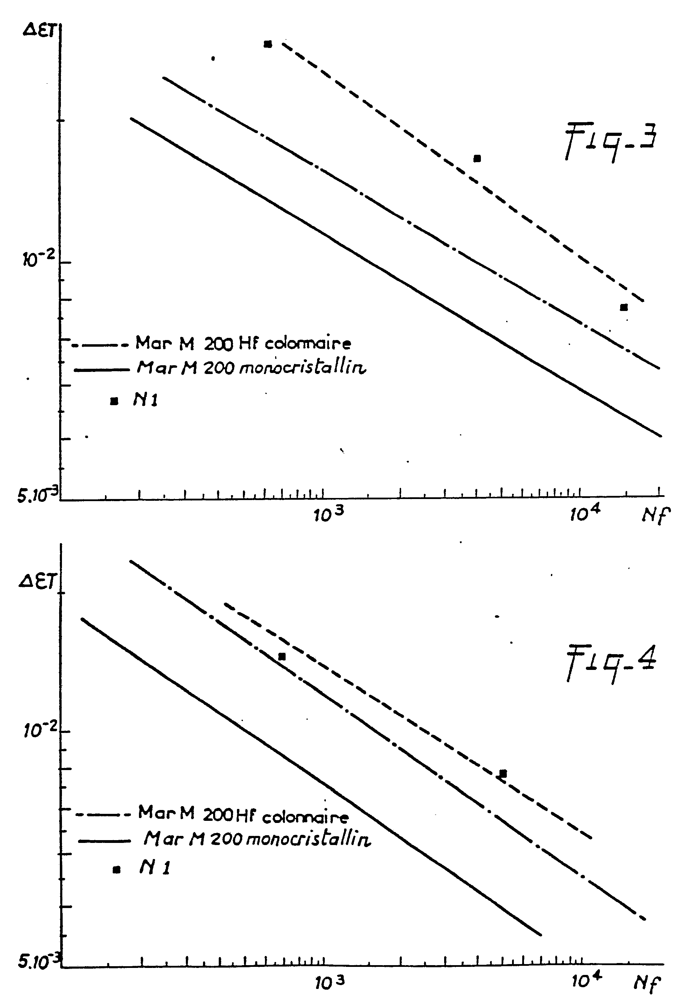

L'augmentation de la teneur en chrome jusqu'à 8 % en poids diminue les températures de liquidus, de solidus et de solvus gamma-prime (cf. fig. 1) et peut entraîner l'apparition d'une phase primaire.

Dans la répartition des éléments gamma-prime-gènes, l'addition d'aluminium est préférée à celle de titane pour tenir compte de l'effet sur l'abaissement de la température de solidus de l'alliage car l'effet de l'aluminium est nettement moindre que celui du titane. Dans la relation définie auparavant entre les compositions atomiques par exemple, le coefficient du titane représentatif de cette influence est de l'ordre de trois fois supérieur à celui de l'aluminium. Pour cette raison, les alliages de l'invention sont exempts de titane.

L'addition de tantale, les autres éléments restant constants par ailleurs, diminue les températures de liquidus et de solidus, sans modifier de façon sensible la température de solvus gamma-prime. La figure 2 a été établie pour une teneur pondérale de tungstène de 11 %. La substitution du niobium (également $\gamma'$-gène) par le tantale est intéressante dans la mesure où le solidus augmente de 15 à 20°C. Mais il est préférable de maintenir la teneur pondérale en tantale inférieure ou égale à 6,5 pour éviter une chute importante de la température de solidus. Cette teneur critique en tantale est fonction de la teneur en tungstène et ainsi pour une teneur

2

pondérale en tungstène de 11, cette teneur critique doit être abaissée à 5,5 (cf figure 2). La teneur en molybdène, élément durcissant, est destinée à conférer une meilleure résistance à la matrice de nickel où il donne lieu à une ségrégation préférentielle.

A titre d'exemple, il a été étudié plus particulièrement trois alliages NI, B et F conformes à l'invention. Leur composition est donnée dans le tableau 1 ci-après où les teneurs sont exprimées en pourcentage pondéral et en pourcentage atomique (entre parenthèses).

Les températures de liquidus, solidus, et solvus gamma- prime pour les alliages de l'invention sont reportées sur le tableau 2 ci-après, où elles sont comparées à celles qui concernent des alliages commerciaux pour monocristaux MarM200, CMSX2, SRR99.

Les alliages conformes à l'invention, élaborés sous forme de monocristaux, font l'objet d'une séquence de traitements thermiques appropriés afin d'optimiser leurs propriétés.

Le traitement thermique débute par une mise en solution des précipités γ'. Elle s'effectue à une température inférieure à la température de solidus entre 1300°C et 1320°C pendant 1 heure à 3 heures et par exemple, 1300°C pendant 1 h pour l'alliage NI). Le refroidissement se fait par trempe à l'air, la taille des précipités γ' est de 0,3 μm.

Deux revenus vers 1100°C pendant 3 heures à 10 heures et vers 850°C pendant 15 heures à 25 heures permettent la précipitation de la phase γ' (la taille des précipités γ' obtenus après un traitement complet de l'alliage NI est 0,4 μm).

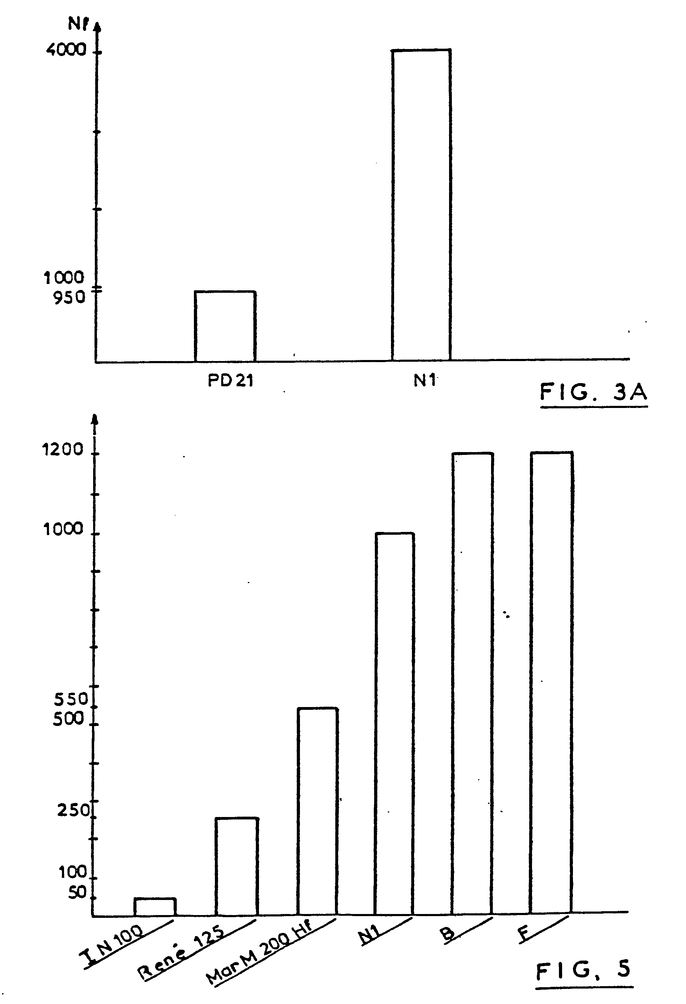

L'alliage NI a été testé en fatigue oligocyclique (déformation totale imposée) à 900°C et à 1000°C. (fig 3 et 4). Il apparaît qu'à 900°C cet alliage présente une durée de vie 5 fois plus grande que celle du MARM 200Hf à structure colonnaire connu pour avoir un bon comportement en fatigue oligocyclique à haute température et en fatigue thermique. La figure 3a montre également les résultats comparatifs en fatigue oligocyclique à 900°C avec une déformation totale imposée de 1,2 % montrant la supériorité de l'alliage selon l'invention NI par rapport à un autre alliage connu de désignation commerciale PD21 correspondant à l'exemple 3 du brevet US-4 174 964.

Ces essais ont été menés sur des éprouvettes traitées mais à l'état nu.

Les essais de fatigue thermique ont été effectués au banc à flamme avec une température maximale de 1100°C. La figure 5 rassemble les résultats obtenus pour les alliages NI, B et F, de l'invention et d'autres alliages à structure colonnaire (MAR M 200 Hf, René 125) ou équiaxe (IN 100) et montre la supériorité des alliages de l'invention pour lesquels les criques et défauts apparaissent au delà de 1000 cycles.

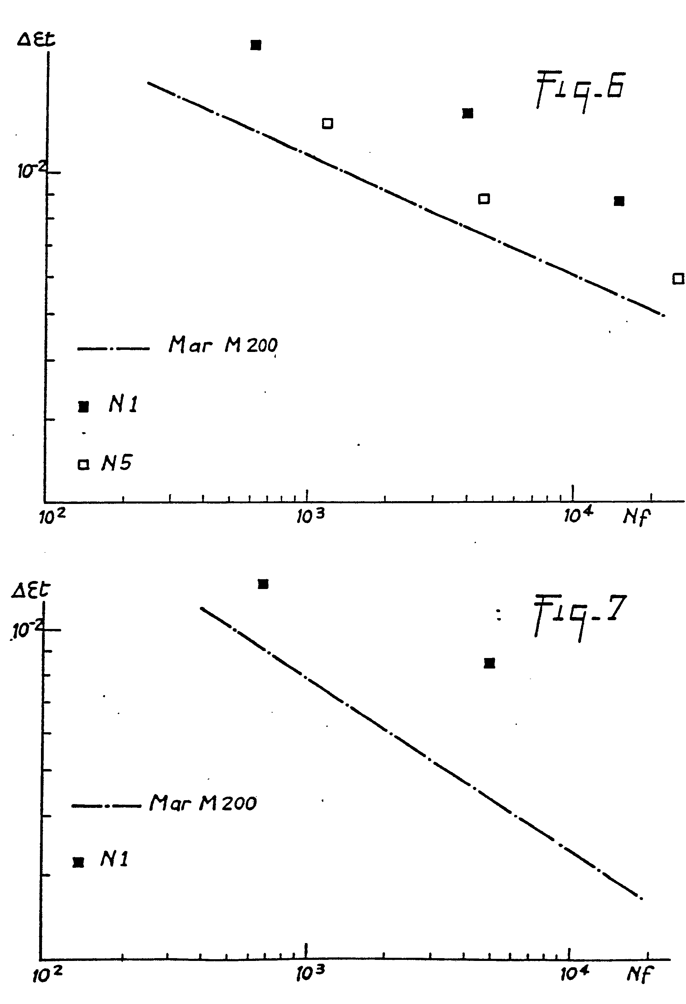

Les figures 6 et 7 concernent des essais de fatigue oligocyclique à déformation imposée réalisés à 900 et 1000°C. Aux deux températures, le MarM200 à structure monocristalline sert de référence. Les courbes donnent le nombre de cycles à rupture en fonction de la déformation totale imposée. A 900°C on a également testé un alliage N5 proche de la famille de l'invention mais non inclus dans ses fourchettes :

| Alliages | Ni | Cr | Mo | W | Ta | Al |
|---|---|---|---|---|---|---|
| N5 | Base | 7,5 | 2 | 11 | 4 | 6 |

Les caractéristiques obtenues sont inférieures à celles de la nuance NI appartenant à la famille d'alliages de l'invention.

L'ensemble des essais réalisés par la Demanderesse montre que les alliages de la famille conformes à l'invention présentent des propriétés améliorées de façon significative en ce qui concerne la fatigue thermique et la tenue en fatigue oligocyclique, tout en ayant, comme recherché, un solidus élevé.

**TABLEAU 1**

| | NI | | B | | F | |
|---|---|---|---|---|---|---|
| | % pond. | % atom | % pond. | % atom | % pond. | % atom |
| Co | 0 | (0) | 5 | (5,14) | 5 | (5,14) |
| Cr | 6 | (6,85) | 6 | (6,99) | 6 | (6,99) |
| Mo | 2 | (1,24) | 2 | (1,26) | 2 | (1,26) |
| Al | 6 | (13,2) | 6 | (13,48) | 6 | (13,48) |
| W | 11 | (3,55) | 11 | (3,62) | 9 | (2,96) |
| Nb | 1,8 | (1,15) | 0 | (0) | 0 | (0) |
| Ta | 0 | (0) | 4 | (1,34) | 6 | (2,01) |
| Ni | complément | complément | complément | | | |

**TABLEAU 2**

| Alliage | Température liquidus(°C) | Température solidus(°C) | Température solvus gamma-prime (°C) |
|---|---|---|---|
| NI | 1398 | 1330 | 1270 |
| B | 1408 | 1350 | 1282 |
| F | 1390 | 1340 | 1295 |
| Mar M200 | 1350 | 1240 | 1200 |
| CMS X 2 | 1375 | 1325 | 1265 |
| SRR 99 | 1370 | 1305 | 1260 |

**Revendications**

1. Alliage monocristallin à matrice à base de nickel, sans addition intentionnelle de carbone, de bore ou de zirconium, caractérisé par la composition pondérale suivante :

| | | | |
|---|---|---|---|
| Co | 0 | à | 10 % |
| Cr | 5 | à | 7 % |
| Mo | 1,5 | à | 2,5 % |
| W | 8,5 | à | 12,5 % |
| Ta | 0 | à | 6,5 % |
| Al | 5 | à | 7 % |
| Nb | 0 | à | 2 % |
| Ni | complément à | 100 | |

avec par ailleurs la somme des pourcentage atomiques :
$0,005Co + 0,036Cr + 0,052Mo + 0,066W + 0,026Al + 0,116Nb + 0,049Ta$ inférieure ou égale à 1, cet alliage étant exempt de titane.

2. Alliage selon la revendication 1 caractérisé en ce que la somme des pourcentages atomiques $Ta + W + Mo + Nb$ est comprise entre 5,9 et 6,3.

3. Alliage selon l'une quelconque des revendications 1 ou 2, caractérisé par la composition pondérale suivante :

| | |
|---|---|
| Co | 0 |
| Cr | 6 |
| Mo | 2 |
| Al | 6 |
| W | 11 |
| Nb | 1,8 |
| Ta | 0 |
| Ni | complément |

4. Alliage selon l'une quelconque des revendications 1 ou 2 caractérisé par la composition pondérale suivante :

| | |
|---|---|
| Co | 5 |
| Cr | 6 |
| Mo | 2 |
| Al | 6 |
| W | 11 |
| Nb | 0 |
| Ta | 4 |
| Ni | complément |

5. Alliage selon l'une quelconque des revendications 1 ou 2 caractérisé par la composition pondérale suivante :

Co 5
Cr 6
Mo 2
Al 6
W 9
Nb 0
Ta 6
Ni complément

6. Alliage selon l'une quelconque des revendications 1 à 5 caractérisé en ce qu'on lui fait subir un traitement thermique à haute température de mise en solution totale de la phase gamma-prime, suivi d'une trempe de précipitation de la phase gamma-prime, complèté par deux revenus.

7. Alliage selon l'une quelconque des revendications 1 à 6 caractérisé en ce que le traitement de mise en solution de la phase gamma-prime est réalisé entre 1300°C et 1320°C pendant 1 heure à 3 heures, et les deux revenus sont réalisés vers 1100° pendant 3 à 10 heures et vers 850°C pendant 15 à 25 heures.

**Patentansprüche**

1. Monokristalline Legierung mit Matrix auf Nickelbasis, ohne vorsätzliche Zugabe von Kohlenstoff, Bor oder Zirkon,
gekennzeichnet durch
folgende Zusammensetzung in Gewichtsprozenten:

Co 0,0 bis 10,0 %
Cr 5,0 bis 7,0 %
Mo 1,5 bis 2,5 %
W 8,5 bis 12,5 %
Ta 0,0 bis 6,5 %
Al 5,0 bis 7,0 %
Nb 0,0 bis 2,0 %
Ni ergänzend auf 100 %

wobei im übrigen aie Summe der Atomprozente 0,005 Co + 0,036 Cr + 0,052 Mo + 0,066 W + 0,026 Al + 0,116 No + 0,049 Ta
kleiner oder gleich 1 ist, wobei die Legierung frei von Titan ist.

2. Legierung nach Anspruch 1,
dadurch gekennzeichnet
daß die Summe der Atomprozente von Ta + W + Mo + Nb zwischen 5,9 und 6,3 % liegt.

3. Legierung nach einem der Ansprüche 1 oder 2,
gekennzeichnet durch
folgende Zusammensetzung in Gewichtsprozenten:

Co 0,0 %
Cr 6,0 %
Mo 2,0 %
Al 6,0 %
W 11,0 %
Nb 1,8 %
Ta 0,0 %
Ni ergänzend auf 100 %.

4. Legierung nach einem der Ansprüche 1 oder 2,
gekennzeichnet durch
folgende Zusammensetzung in Gewichtsprozenten:

Co 5,0 %
Cr 6,0 %
Mo 2,0 %
Al 6,0 %
W 11,0 %
Nb 0,0 %
Ta 4,0 %
Ni ergänzend auf 100 %.

5

## 0 194 925

5. Legierung nach einem beliebigen der Ansprüche 1 oder 2,
gekennzeichnet durch
folgende Zusammensetzung in Gewichtsprozenten:

| | |
|---|---|
| Co | 5,0 % |
| Cr | 6,0 % |
| Mo | 2,0 % |
| Al | 6,0 % |
| W | 9,0 % |
| Nb | 0,0 % |
| Ta | 6,0 % |
| Ni | ergänzend auf 100 %. |

6. Legierung nach einem der Ansprüche 1 bis 5,
dadurch gekennzeichnet,
daß diese einer Wärmebehandlung bei hoher Temperatur wegen des vollständigen Übergangs in eine Lösung der Gamma-Primär-Phase ausgesetzt wird, gefolgt von einer Ausscheidungshärtung der Gamma-Primär-Phase, vervollständigt durch zweimalige Wiederholung.

7. Legierung nach einem der Ansprüche 1 bis 6,
dadurch gekennzeichnet,
daß die Behandlung zum vollständigen Übergang in eine Lösung der Gamma-Primär-Phase zwischen 1.300 und 1.320°C während 1 bis 3 Stunden erfolgt und daß die zwei Wiederholungen bei etwa 1.100°C während 3 bis 10 Stunden und etwa 850°C während 15 bis 25 Stunden erfolgen.

## Claims

1. Monocrystalline alloy with a nickel-based matrix, without deliberate addition of carbon, boron or zirconium, characterized by the folloving composition by weight:

| | | | |
|---|---|---|---|
| Co | 0 | to | 10 % |
| Cr | 5 | to | 7 % |
| Mo | 1.5 | to | 2.5 % |
| W | 8.5 | to | 12.5 % |
| Ta | 0 | to | 6.5 % |
| Al | 5 | to | 7 % |
| Nb | 0 | to | 2 % |
| Ni | remainder | to | 100 |

with, furthermore, the sum of the atomic percentages:
$0.005Co + 0.036Cr + 0.052Mo + 0.066W + 0.026Al + 0.116Nb + 0.049Ta$ lower than or equal to 1, this alloy being free from titanium.

2. Alloy according to Claim 1, characterized in that the sum of the atomic percentages $Ta + W + Mo + Nb$ is between 5.9 and 6.3.

3. Alloy according to either of Claims 1 and 2, characterized by the following composition by weight:

| | |
|---|---|
| Co | 0 |
| Cr | 6 |
| Mo | 2 |
| Al | 6 |
| W | 11 |
| Nb | 1.8 |
| Ta | 0 |
| Ni | remainder |

4. Alloy according to either of Claims 1 and 2, characterized by the following composition by weight:

| | |
|---|---|
| Co | 5 |
| Cr | 6 |
| Mo | 2 |
| Al | 6 |
| W | 11 |
| Nb | 0 |
| Ta | 4 |
| Ni | remainder |

5. Alloy according to either of Claims 1 and 2, characterized by the following composition by weight:

| | |
|---|---|
| Co | 5 |
| Cr | 6 |
| Mo | 2 |
| Al | 6 |
| W | 9 |
| Nb | 0 |
| Ta | 6 |
| Ni | remainder |

6. Alloy according to any one of Claims 1 to 5, characterized in that it is subjected to a high- temperature heat treatment for completely dissolving the gamma-prime phase, followed by a quenching for precipitating the gamma-prime phase, and completed by two annealings.

7. Alloy according to any one of Claims 1 to 6, characterized in that the treatment for dissolving the gamma-prime phase is carried out between 1300°C and 1320°C for 1 hour to 3 hours, and the two annealings are carried out at about 1100° for 3 to 10 hours and at about 850°C for 15 to 25 hours.

Fig. 1

Fig. 2

0 194 925

Fig-3

Mar M 200 Hf colonnaire
Mar M 200 monocristallin
N 1

Fig-4

Mar M 200 Hf colonnaire
Mar M 200 monocristallin
N 1

3

FIG. 3A

FIG. 5

Fig-6

Fig-7

0 194 925